# FASCICULE DE BREVET EUROPEEN

(11) **EP 3 513 118 B1**
(45) Date de publication et mention de la délivrance du brevet: **24.05.2023**
(21) Numéro de dépôt: 17761815.4
(22) Date de dépôt: 26.07.2017
(51) Int. Cl.: F21S 41/00, H01L 27/15

(54) **PROCÉDÉ DE MONTAGE D'UN COMPOSANT ÉLECTROLUMINESCENT MATRICIEL SUR UN SUPPORT**
VERFAHREN ZUR MONTAGE EINER LICHTEMITTIERENDEN MATRIXKOMPONENTE AUF EINEM TRÄGER
METHOD FOR MOUNTING A LIGHT-EMITTING MATRIX COMPONENT ON A SUPPORT

(30) Priorité: 15.09.2016 FR 1658628
(43) Date de publication de la demande: 24.07.2019
(73) Titulaire: Valeo Vision, 93012 Bobigny Cedex (FR)
(72) Inventeur: LEFAUDEUX, Nicolas, 93012 Bobigny Cedex (FR); DE LAMBERTERIE, Antoine, 93012 Bobigny Cedex (FR); THIN, Guillaume, 93012 Bobigny Cedex (FR); CANONNE, Thomas, 93012 Bobigny Cedex (FR); MBATA, Samira, 93012 Bobigny Cedex (FR); DUBOIS, Vincent, 93012 Bobigny Cedex (FR); AMIEL, François-Xavier, 93012 Bobigny Cedex (FR); HOANG, Van-Thai, 93012 Bobigny Cedex (FR)
(74) Mandataire: Valeo Visibility
(86) Numéro de dépôt international: PCT/EP2017/068936
(87) Numéro de publication internationale: WO 2018/050339

(56) Documents cités:
- WO-A1-2011/000898
- WO-A1-2016/015174
- WO-A1-2016/015174
- WO-A1-2016/108021
- DE-A1-102011 056 888
- DE-A1-102011 056 888
- US-A1- 2012 223 875
- US-A1- 2012 223 875
- US-A1- 2015 362 165
- US-A1- 2015 362 165
- US-A1- 2016 027 765
- US-A1- 2016 027 765

## Description

L'invention a trait aux procédés d'assemblages des composants lumineux pour l'utilisation dans des modules lumineux pour véhicules automobiles sur un substrat. En particulier, l'invention se rapporte à la fixation de composants comprenant un arrangement de plusieurs sources élémentaires à semi-conducteurs électroluminescents, arrangés en forme de matrice, sur un substrat.

L'utilisation de diodes électroluminescentes, LED, à consommation d'énergie généralement faible, est de plus en plus préconisée dans le domaine des véhicules automobiles, afin de réaliser des fonctions lumineuses telles que les feux diurnes, feux de signalisation, ou par exemple les feux indicateurs de direction. Une LED émet de la lumière lorsqu'une tension de charge ayant au moins une valeur prédéterminée est appliquée à ces bornes. L'intensité de la lumière émise par une LED est en général une fonction de l'intensité du courant de charge qui la traverse.

Dans le domaine des dispositifs lumineux pour véhicules automobiles, il est connu d'avoir recours à des modules impliquant une pluralité de LEDs montées en forme d'une matrice généralement rectangulaire. Chaque LED est une source lumineuse élémentaire qui est avantageusement pilotée en courant électrique de manière individuelle et indépendamment des autres LEDs de la matrice. De fait, chaque LED peut être considérée comme représentant un pixel d'une plage rectangulaire, dont l'intensité lumineuse peut être déterminée selon les besoins de l'application visée. Lorsque toutes les LEDs d'un tel module émettent de la lumière de manière uniforme, le module peut être assimilé à une source réalisant une empreinte optique généralement rectangulaire. Cependant, en alimentant de manière sélective des sous-ensembles de pixels, il devient possible de créer des empreintes optiques présentant des géométries diverses. A titre exemplaire, une telle configuration permet de réaliser un feu avant qui n'éblouit pas le trafic croisant, en baissant de manière sélective la luminosité uniquement des pixels qui illuminent le côté central ou gauche de la route, tout en illuminant de manière substantielle le côté droit de la route. Evidemment des configurations plus complexes sont également réalisables à l'aide de tels dispositifs.

Afin de pouvoir profiter au maximum des possibilités fournies par des technologies à matrices de LEDs, des sources à densités de pixels élevées sont de plus en plus demandées. Ceci implique que la distance entre les sources lumineuses élémentaires ou LEDs de la source matricielle devient de plus en plus petite. Des composants lumineux dits « monolithiques » peuvent présenter une densité de sources lumineuses particulièrement élevée, ce qui les rend particulièrement intéressant pour une pluralité d'applications. De tels composants impliquent une pluralité d'éléments semi-conducteurs électroluminescents à dimensions submillimétriques, épitaxiés directement sur un substrat commun, le substrat étant généralement formé de silicium. A l'opposé de matrices de LEDs conventionnelles, dans lesquelles chaque source lumineuse élémentaire est un composant électronique produit de manière individuelle et monté sur un substrat tel qu'un circuit imprimé, PCB, un composant monolithique est à considérer comme un composant électronique unique, lors de la production duquel plusieurs plages de jonctions semi-conductrices électroluminescentes sont générées sur un substrat commun, sous forme d'une matrice. Cette technique de production permet de réaliser des plages électroluminescentes, faisant chacune office de source lumineuse élémentaire, très rapprochées les unes des autres. Les interstices entre les sources élémentaires peuvent présenter des dimensions submillimétriques. Un avantage de cette technique de production est le niveau élevé de la densité de pixels qui peut en résulter sur un substrat unique.

Afin de piloter l'alimentation électrique d'un tel composant matriciel monolithique, et en particulier le pilotage d'éléments lumineux individuels de la matrice, il est nécessaire de prévoir des connexions électriques entre des moyens de pilotage de l'alimentation et chacune des sources, engendrant un réseau complexe de liaisons entre le composant et un support sur lequel il est posé. Ces connexions donnent en général lieu à un encombrement important sur la surface arrière du composant monolithique, qui forme l'interface avec la face d'un support, d'autant plus que les sources lumineuses élémentaires sont très proches les unes des autres. Cette surface doit cependant également faire office de surface d'échange thermique, d'autant plus que la densité élevée de sources lumineuses du composant en fait une source de chaleur importante. Il est connu de remplir les interstices entre les câblages électriques du composant matriciel monolithique à l'aide d'une matière de remplissage, typiquement une résine thermo-conductrice, afin d'assurer la dissipation de la chaleur ainsi produite vers la surface du support. Cependant, de telles solutions connues engendrent des étapes supplémentaires (pose du matériel de remplissage) lors de l'assemblage des composants sur un support. Les documents US 2015/362165 A1 et WO 2016/108021 A1 décrivent des procédés de montage d'un composant lumineux sur un support.

L'invention a pour objectif de pallier au moins un des problèmes posés par l'art antérieur. En particulier, l'invention a pour objectif de proposer un procédé permettant de réaliser des matrices de sources lumineuses électroluminescentes à densité de pixels élevée, sans sacrifier le pouvoir de résolution d'une telle matrice. L'invention a en outre l'objectif de proposer un dispositif issu d'un tel procédé.

L'invention a pour objet un procédé de montage d'un composant lumineux sur un support.

Le composant lumineux comprend un substrat généralement plan sur une première face duquel des éléments semi-conducteurs électroluminescents à dimensions submillimétriques sont épitaxiés sous la forme d'une matrice. Le procédé est remarquable en ce qu'il comprend les étapes suivantes :
- génération d'au moins une piste électriquement conductrice sur la deuxième face du substrat du composant lumineux;
- génération d'au moins une piste électriquement conductrice sur une face du support ;
- positionnement du composant lumineux sur ladite face du support, de manière à ce que les pistes électriquement conductrices du composant et du support soient en contact ;
- recuit de l'ensemble composé du support et du composant lumineux à une température comprise entre 200° et 400°C ;
dans lequel la génération de pistes électriquement conductrices sur le composant lumineux et sur le substrat comprend l'utilisation d'un procédé photolithographique pour réaliser des évidements dans le substrat et dans le support, du cuivre ou un matériau comprenant du cuivre étant déposé dans les évidements de sorte que les pistes électriquement conductrices comprennent du cuivre.

L'épitaxie est une technique de croissance orientée de cristaux communément utilisée pour créer des jonctions semi-conductrices.

De préférence, les pistes électriquement conductrices générées sur la deuxième face du substrat du composant lumineux peuvent être disposées de manière à permettre l'alimentation en courant électrique de chacun des éléments semi-conducteurs électroluminescents du composant lumineux.

Les pistes électriquement conductrices sont des pistes qui comprennent du cuivre. Avantageusement les pistes sont en cuivre.

Le substrat du composant lumineux peut préférentiellement comprendre du Silicium, du saphir, du carbure de Silicium ou du nitrure de Galium.

De manière préférée le support peut comprendre du Silicium ou du verre.

La génération de pistes comprenant du cuivre sur le composant lumineux et sur le substrat comprend l'utilisation d'un procédé photolithographique pour réaliser des évidements dans le substrat et dans le support. De préférence, du cuivre peut être déposé dans les évidements.

De préférence, le support et/ou le composant lumineux peuvent comprendre des marques d'alignement destinées à faciliter le positionnement du composant sur le support.

L'invention a également pour objet un module lumineux pour un véhicule automobile. Le module lumineux est remarquable en ce qu'il comprend des moyens de pilotage de l'alimentation électrique d'une pluralité d'éléments semi-conducteurs électroluminescents à dimensions submillimétriques épitaxiés sous la forme d'une matrice sur un substrat généralement plan d'au moins un composant lumineux, et en ce que ledit composant lumineux est monté sur un support à l'aide du procédé conforme à l'invention.

Le support peut de préférence être électriquement relié aux moyens de pilotage, ou peut comprendre sur une de ses faces les moyens de pilotage de l'alimentation électrique.

De préférence, les pistes électriquement conductrices générées sur le support peuvent être électriquement reliées aux moyens de pilotage de l'alimentation électrique.

Les mesures selon la présente invention permettent de simplifier des procédés de montage connus d'un composant lumineux matriciel monolithique sur un support. L'utilisation d'une liaison cuivre-cuivre entre le composant lumineux et son support permet de s'affranchir de l'utilisation d'un matériau de remplissage, tel qu'une résine thermo-conductrice, entre le composant lumineux et le support. La liaison cuivre-cuivre assure en même temps la fixation mécanique du composant électrique sur son support, les connexions électriques nécessaires entre chaque source lumineuse électroluminescente élémentaire du composant matriciel monolithique, et en plus elle assure un bon échange thermique entre le composant et son support, ce qui est d'autant plus important que la densité élevée de sources lumineuses présentes sur un composant matriciel monolithique en fait une source de chaleur non-négligeable.

D'autres caractéristiques et avantages de la présente invention seront mieux compris à l'aide de la description exemplaire et des dessins parmi lesquels :
- la figure 1 montre de manière schématique un ensemble constitué d'un composant lumineux électroluminescent matriciel fixé sur un support selon un procédé connu de l'état de l'art ;
- la figure 2 montre de manière schématique les étapes principales selon un mode de réalisation préférentiel du procédé selon l'invention ;
- la figure 3 montre de manière schématique une coupe à travers un composant lumineux électroluminescent matriciel lors du traitement selon une des étapes du procédé selon l'invention ;
- la figure 4 montre de manière schématique un ensemble constitué d'un composant lumineux électroluminescent matriciel fixé sur un support selon un mode de réalisation préférentiel du procédé selon l'invention.

Sauf indication spécifique du contraire, des caractéristiques techniques décrites en détails pour un mode de réalisation donné peuvent être combinées aux caractéristiques techniques décrites dans le contexte d'autres modes de réalisation décrits à titre exemplaire et non limitatif.

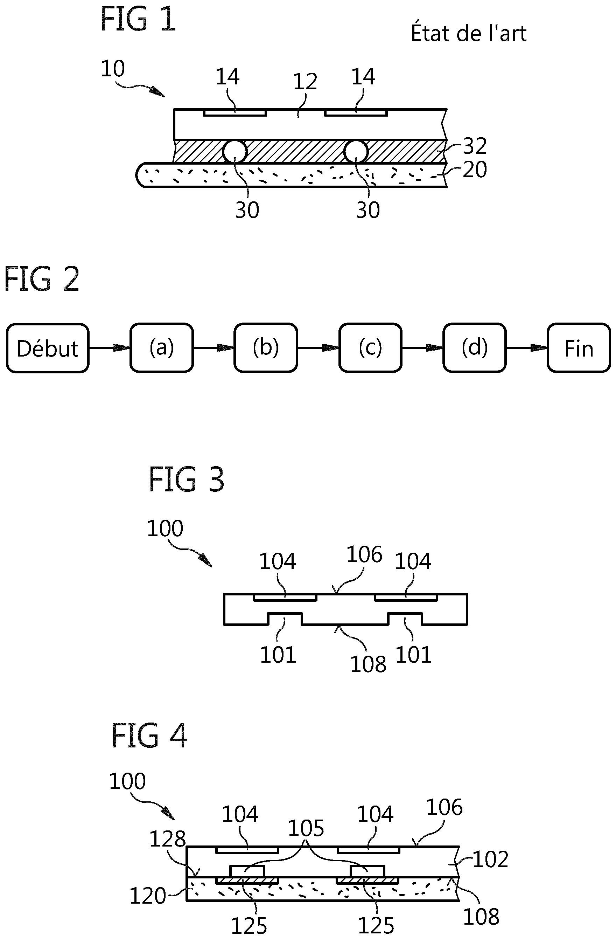

La figure 1 montre de manière schématique une solution connue de l'état de l'art, selon laquelle un composant lumineux 10 est fixé sur un support 20 généralement plan. Le composant 10 est un composant dit « monolithique » comprenant un substrat 12 sur lequel sont épitaxiées des sources lumineuses électroluminescentes élémentaires 14 à dimensions submillimétriques. Des connexions électriques, indiquées par les câbles 30 sont prévues entre le composant 10 et son support 20. Ces connexions assurent l'alimentation électrique de chacune des sources élémentaires 14 du composant matriciel 10. L'interstice vide entre les câbles 30 est rempli d'une résine thermo-conductrice 32, qui assure la bonne tenue du composant 10 sur le support 20, ainsi que l'échange thermique entre le composant 10 et le support 20.

Les étapes principales d'un mode de réalisation préférentiel du procédé selon l'invention sont indiquées sur la figure 2. Lors d'une première étape a), on génère au moins une piste électriquement conductrice, comprenant par exemple du cuivre, sur la face arrière du substrat du composant lumineux matriciel. Il s'agit de la face qui ne comprend pas les sources lumineuses élémentaires. De même, au moins une piste électriquement conductrice, comprenant du cuivre, est générée sur une face du support sur lequel le composant matriciel doit être fixé. Ceci correspond à l'étape b). Il va de soi que les étapes a) et b) peuvent être inversées dans leur ordre ou réalisées simultanément en parallèle, sans pour autant sortir du cadre de la présente invention. Lors de l'étape suivante c), le composant lumineux et le support ainsi préparés sont positionnés de manière à ce que les pistes comprenant du cuivre qui ont été générées aux étapes précédentes soient en contact.

D'autres matières ou métaux électriquement conducteurs peuvent être utilisés en remplacement du cuivre, pour autant qu'elles présentent des propriétés semblables, sans pour autant faire partie de la présente invention.

Ensuite, l'ensemble composé du support et du composant lumineux est recuit dans un four prévu à cet effet, à une température comprise entre 200° et 400°C. Ceci correspond à l'étape finale d). Lors du recuit, une connexion dite hybride (« hybrid bonding ») se crée entre le composant matriciel et son support. Cette connexion composant-support est électriquement et thermiquement conductrice, et assure en même temps la bonne tenue mécanique du composant matriciel sur le support. Le procédé ne requiert pas l'utilisation de colle ni l'application de pression sur les composants lors de l'assemblage sur le support et crée une connexion directe sans donner lieu à une vide entre le composant et le support.

La figure 3 donne une illustration d'un composant électroluminescent 100 lors de l'étape a) du procédé qui vient d'être décrit. Le composant 100 comprend une première face 106 sur laquelle sont épitaxiées les sources électroluminescentes 104 sous la forme d'une matrice. Sur une deuxième face 108, qui est située du côté arrière de la première face 106, on crée des évidements 101. Le substrat 106 comprend de préférence du Silicium, du GaN, du saphir ou du carbure de Silicium. Les évidements sont dessinés de manière à correspondre au réseau de connexions électriques nécessaires à l'alimentation électrique de chacune des sources élémentaires 104. A cette fin, des procédés photolithographiques en soi connus dans l'art, qui ne seront pas décrits en détails dans le cadre la présente invention, sont utilisés. Une fois que les évidements ont été créés, du cuivre est déposé au fond des évidements, pour les remplir. Une étape optionnelle de polissage peut être envisagée afin de garantir une interface généralement lisse entre les évidements 101 ainsi remplis et la surface 108. Un procédé similaire est mis en oeuvre pour générer les pistes contenant du cuivre sur la surface du support.

La figure 4 montre le résultat du procédé selon l'invention. Le composant 100 comprend une première face 106 sur laquelle sont épitaxiées les sources électroluminescentes 104 sous la forme d'une matrice. Sur une deuxième face 108, des évidements créent un réseau de nervures à l'image des connexions électriques nécessitées. Les nervures ou évidements sont remplis de cuivre 105. Le support 128, comprenant du Silicium ou du verre présente sur sa face 128 des pistes en cuivre 125 qui correspondent aux pistes 105 sur la face arrière 108 du composant 100. Lors du recuit de l'ensemble formé par le composant 100 et le support 120, la connexion hybride requise se crée au niveau des plages 105 et 125 respectivement.

Selon un mode de réalisation préférentiel, les pistes électriquement conductrices 125 sont fonctionnellement reliées à des moyens de pilotage de l'alimentation des sources lumineuses 104. De tels moyens sont connus dans l'art et impliquent généralement des éléments convertisseurs configurés pour transformer un courant direct d'une première intensité, fourni en général par une source de courant interne au véhicule automobile dans lequel le composant 100 trouve son application, en un courant de charge d'une deuxième intensité, appropriée à l'alimentation sélective des sources lumineuses 104 du composant 100. Un module lumineux pour un véhicule automobile peut avantageusement également comprendre des moyens de commande réalisés sous forme d'un élément microcontrôleur, qui permettent de commander les moyens de pilotage de l'alimentation afin de répondre à des consignes reçues d'autres organes du véhicule automobile.

## Revendications

1. Procédé de montage d'un composant lumineux (100) sur un support (120), le composant lumineux comprenant un substrat (102) généralement plan sur une première face (106) duquel des éléments semi-conducteurs électroluminescents (104) à dimensions submillimétriques sont épitaxiés sous la forme d'une matrice, et le procédé comprenant les étapes suivantes :
a) génération d'au moins une piste (105) électriquement conductrice sur la deuxième face (108) du substrat du composant lumineux:
b) génération d'au moins une piste (125) électriquement conductrice sur une face (128) du support ;
c) positionnement du composant lumineux (100) sur ladite face (128) du support, de manière à ce que les pistes (105,125) électriquement conductrices du composant et du support soient en contact ;
d) recuit de l'ensemble composé du support (120) et du composant lumineux (100) à une température comprise entre 200° et 400°C ;
**caractérisé en ce que** la génération de pistes (105,125) électriquement conductrices sur le composant lumineux et sur le substrat comprend l'utilisation d'un procédé photolithographique pour réaliser des évidements dans le substrat et dans le support, du cuivre ou un matériau comprenant du cuivre étant déposé dans les évidements de sorte que les pistes électriquement conductrices comprennent du cuivre.

2. Procédé selon la revendication 1, dans lequel les pistes électriquement conductrices générées sur la deuxième face du substrat du composant lumineux sont disposées de manière à permettre l'alimentation en courant électrique de chacun des éléments semi-conducteurs électroluminescents du composant lumineux.

3. Procédé selon une des revendications 1 à 2, dans lequel le substrat du composant lumineux comprend du Silicium, du saphir, du carbure de Silicium ou du nitrure de Galium.

4. Procédé selon une des revendications 1 à 3, dans lequel le support comprend du Silicium ou du verre.

5. Procédé selon une des revendications 1 à 4, dans lequel le support et le composant lumineux comprennent des marques d'alignement destinées à faciliter le positionnement du composant sur le support.

6. Module lumineux pour un véhicule automobile, **caractérisé en ce que** le module comprend des moyens de pilotage de l'alimentation électrique d'une pluralité d'éléments semi-conducteurs électroluminescents à dimensions submillimétriques épitaxiés sous la forme d'une matrice sur un substrat généralement plan d'au moins un composant lumineux, et **en ce que** ledit composant lumineux est monté sur un support à l'aide du procédé selon une des revendications 1 à 5.

7. Module lumineux selon la revendication 6, dans lequel le support est électriquement relié, ou comprend sur une de ses faces, les moyens de pilotage de l'alimentation électrique.

8. Module lumineux selon une des revendications 6 ou 7, dans lequel les pistes électriquement conductrices générées sur le support sont électriquement reliées aux moyens de pilotage de l'alimentation électrique.

## Patentansprüche

1. Verfahren zur Montage einer leuchtenden Komponente (100) auf einem Träger (120), wobei die leuchtende Komponente ein allgemein ebenes Substrat (102) umfasst, auf dessen erster Seite (106) lichtemittierende Halbleiterelemente (104) mit submillimetrischen Abmessungen in Form einer Matrix epitaxiert sind, und wobei das Verfahren die folgenden Schritte umfasst:
a) Erzeugen mindestens einer elektrisch leitenden Bahn (105) auf der zweiten Seite (108) des Substrats der leuchtenden Komponente;
b) Erzeugen mindestens einer elektrisch leitenden Bahn (125) auf einer Seite (128) des Trägers;
c) Positionieren der leuchtenden Komponente (100) auf der Seite (128) des Trägers derart, dass die elektrisch leitenden Bahnen (105, 125) der Komponenten und des Trägers in Kontakt sind;
d) Glühen der aus dem Träger (102) und der leuchtenden Komponente (100) zusammengesetzten Einheit bei einer Temperatur zwischen 200 ° und 400 °C;
**dadurch gekennzeichnet, dass** das Erzeugen von elektrisch leitenden Bahnen (105, 125) auf der leuchtenden Komponente und auf dem Substrat die Verwendung eines fotolitografischen Verfahrens umfasst, um Ausnehmungen in dem Substrat und in dem Träger auszuführen, wobei Kupfer oder ein Kupfer umfassendes Material in den Ausnehmungen abgeschieden wird, so dass die elektrisch leitenden Bahnen Kupfer umfassen.

2. Verfahren nach Anspruch 1, bei dem die auf der zweiten Seite des Substrats der leuchtenden Komponente erzeugten elektrisch leitenden Bahnen derart angeordnet sind, dass sie die Versorgung mit elektrischen Strom jedes der lichtemittierenden Halbleiterelemente der leuchtenden Komponente ermöglichen.

3. Verfahren nach einem der Ansprüche 1 bis 2, bei dem das Substrat der leuchtenden Komponente Silicium, Saphir, Siliciumcarbid oder Galliumnitrid umfasst.

4. Verfahren nach einem der Ansprüche 1 bis 3, bei dem der Träger Silicium oder Glas umfasst.

5. Verfahren nach einem der Ansprüche 1 bis 4, bei dem der Träger und die leuchtende Komponente Ausrichtmarken umfassen, die dazu bestimmt sind, das Positionieren der Komponente auf dem Träger zu erleichtern.

6. Leuchtendes Modul für ein Kraftfahrzeug, **dadurch gekennzeichnet, dass** das Modul Mittel zur Ansteuerung der elektrischen Versorgung einer Mehrzahl von lichtemittierenden Halbleiterelementen mit submillimetrischen Abmessungen, die in Form einer Matrix auf ein allgemein ebenes Substrat mindestens einer leuchtenden Komponente epitaxiert sind, umfasst, und dadurch, dass die leuchtende Komponente mithilfe des Verfahrens nach einem der Ansprüche 1 bis 5 auf einem Träger montiert wird.

7. Leuchtendes Modul nach Anspruch 6, bei dem der Träger elektrisch verbunden ist oder auf einer seiner Seiten die Mittel zur Ansteuerung der elektrischen Versorgung umfasst.

8. Leuchtendes Modul nach einem der Ansprüche 6 oder 7, bei dem die auf dem Träger erzeugten elektrisch leitenden Bahnen mit den Mitteln zur Ansteuerung der elektrischen Versorgung elektrisch verbunden sind.

## Claims

1. Method for mounting a light component (100) on a carrier (120), the light component comprising a generally planar substrate (102), on a first face (106) of which submillimetre-sized electroluminescent semiconductor elements (104) are grown epitaxially in the form of a matrix, and the method comprising the following steps:
a) forming at least one electrically conductive track (105) on the second face (108) of the substrate of the light component;
b) forming at least one electrically conductive track (125) on a face (128) of the carrier;
c) positioning the light component (100) on said face (128) of the carrier, such that the electrically conductive tracks (105, 125) of the component and of the carrier are in contact;
d) annealing the assembly composed of the carrier (120) and of the light component (100) at a temperature of between 200°C and 400°C;
**characterized in that** the formation of electrically conductive tracks (105, 125) on the light component and on the substrate comprises the use of a photolithographic process to produce voids in the substrate and in the carrier, copper or a material comprising copper being deposited in the voids so that the electrically conductive tracks comprise copper.

2. Method according to Claim 1, wherein the electrically conductive tracks formed on the second face of the substrate of the light component are disposed so as to allow each of the electroluminescent semiconductor elements of the light component to be supplied with electric current.

3. Method according to either of Claims 1 to 2, wherein the substrate of the light component comprises silicon, sapphire, silicon carbide or gallium nitride.

4. Method according to one of Claims 1 to 3, wherein the carrier comprises silicon or glass.

5. Method according to one of Claims 1 to 4, wherein the carrier and the light component comprise alignment marks that are intended to make it easier to position the component on the carrier.

6. Light module for a motor vehicle, **characterized in that** the module comprises means for driving the electrical power supply of a plurality of submillimetre-sized electroluminescent semiconductor elements that are grown epitaxially in the form of a matrix on a generally planar substrate of at least one light component, and **in that** said light component is mounted on a carrier using the method according to one of Claims 1 to 5.

7. Light module according to Claim 6, wherein the carrier is electrically connected to, or comprises on one of its faces, the means for driving the electrical power supply.

8. Light module according to either of Claims 6 and 7, wherein the electrically conductive tracks formed on the carrier are electrically connected to the means for driving the electrical power supply.
